# EUROPEAN PATENT APPLICATION

(11) **EP 4 769 637 A1**
(43) Date of publication of application: **01.07.2026**
(21) Application number: 25833494.5
(22) Date of filing: 01.07.2025
(51) Int. Cl.: H01M 10/42, H01M 50/533, G01R 31/52, H01M 50/449

(54) **VARIABLE RESISTOR STRUCTURE, ELECTRODE ASSEMBLY INCLUDING SAME, BATTERY CELL, BATTERY CELL ASSEMBLY, AND BATTERY PACK**

(30) Priority: 03.07.2024 KR 20240087564
(71) Applicant: LG Energy Solution, Ltd., Seoul 07335 (KR)
(72) Inventor: LEE, Sang Jae, Daejeon 34122 (KR); KWON, Kyeong Keun, Daejeon 34122 (KR); JEONG, Seo Young, Daejeon 34122 (KR)
(74) Representative: Goddar, Heinz J.
(86) International application number: PCT/KR2025/009294
(87) International publication number: WO 2026/010308

(57) **Abstract**

Embodiments provide an electrode assembly. The electrode assembly includes: a positive electrode including a positive electrode current collector, a first positive electrode active material layer on the positive electrode current collector, and a second positive electrode active material layer spaced apart from the first positive electrode active material layer with the positive electrode current collector therebetween; a negative electrode including a negative electrode current collector, a first negative electrode active material layer on the negative electrode current collector, and a second negative electrode active material layer spaced apart from the first negative electrode active material layer with the negative electrode current collector therebetween; a separator between the positive electrode and the negative electrode; and a variable resistance structure in contact with the positive electrode and the negative electrode, the variable resistance structure includes a conductive foil and a variable resistance film on the conductive foil, and the variable resistance film includes a transition metal oxide.

## Description

### [Technical Field]

The present disclosure relates to a variable resistance structure, an electrode assembly including the same, a battery cell, a battery cell assembly, and a battery pack. The present application claims the benefit of priority based on Korean Patent Application No. 10-2024-0087564, filed on July 3, 2024, and the entire contents of the Korean patent application are incorporated herein by reference.

### [Background Art]

Secondary batteries can be charged and discharged a plurality of times unlike primary batteries. Secondary batteries are widely used as energy sources for various types of wireless devices such as handsets, laptop computers, and cordless vacuum cleaners. Recently, the main use of secondary batteries is moving from mobile devices to mobility, as manufacturing costs per unit capacity of secondary batteries drastically decrease due to improvements in energy density and economies of scale and a range of battery electric vehicles (BEVs) increases to the same level as fuel vehicles.

A trend in the development of technology for secondary batteries for mobility is an improvement in energy density and safety. The safety of secondary batteries for mobility is directly related to passengers' lives and thus is very important. A typical method of testing the safety of a secondary battery is an internal short circuit test.

### [Disclosure]

### [Technical Problem]

The present disclosure is directed to providing a variable resistance structure with improved reliability, an electrode assembly including the same, a battery cell, a battery cell assembly, and a battery pack.

### [Technical Solution]

Embodiments of the present disclosure provide an electrode assembly. The electrode assembly includes: a positive electrode including a positive electrode current collector, a first positive electrode active material layer on the positive electrode current collector, and a second positive electrode active material layer spaced apart from the first positive electrode active material layer with the positive electrode current collector therebetween; a negative electrode including a negative electrode current collector, a first negative electrode active material layer on the negative electrode current collector, and a second negative electrode active material layer spaced apart from the first negative electrode active material layer with the negative electrode current collector therebetween; a separator between the positive electrode and the negative electrode; and a variable resistance structure in contact with the positive electrode and the negative electrode, the variable resistance structure includes a conductive foil and a variable resistance film on the conductive foil, and the variable resistance film includes a transition metal oxide.

The variable resistance film may include VO₂.

The variable resistance structure may have a step shape.

The positive electrode current collector may include a positive electrode tab, and the variable resistance structure may include a first portion on the positive electrode tab and a second portion between the negative electrode and the separator.

The conductive foil may be in contact with the positive electrode tab.

The conductive foil may be coupled to the positive electrode tab via an adhesive.

The conductive foil may be spaced apart from the second negative electrode active material layer with the variable resistance film therebetween.

The variable resistance film may be in contact with the second negative electrode active material layer.

The variable resistance structure may further include an insulating layer between the variable resistance film and the negative electrode.

The conductive foil may be in contact with the second negative electrode active material layer.

The conductive foil may be spaced apart from the positive electrode tab with the variable resistance film therebetween.

The variable resistance film may be in contact with the positive electrode tab.

The negative electrode current collector may include a negative electrode tab, and the variable resistance structure may include a first portion on the negative electrode tab and a second portion between the positive electrode and the separator.

The variable resistance structure may include a first portion between the positive electrode and the separator and a second portion between the negative electrode and the separator.

The positive electrode current collector may include a positive electrode tab, the negative electrode current collector may include a negative electrode tab, and the variable resistance structure may be spaced apart from each of the positive electrode tab and the negative electrode tab.

The variable resistance structure may have a C-shape.

Embodiments provide an electrode assembly. The electrode assembly includes: a positive electrode including a positive electrode current collector, a first positive electrode active material layer on the positive electrode current collector, and a second positive electrode active material layer spaced apart from the first positive electrode active material layer with the positive electrode current collector therebetween; a negative electrode including a negative electrode current collector, a first negative electrode active material layer on the negative electrode current collector, and a second negative electrode active material layer spaced apart from the first negative electrode active material layer with the negative electrode current collector therebetween; a separator between the positive electrode and the negative electrode; and a variable resistance structure in contact with the positive electrode and the negative electrode, the variable resistance structure includes a conductive foil and a variable resistance film on the conductive foil, and first resistivity of the variable resistance film at a first temperature is twice or more second resistivity of the variable resistance film at a second temperature higher than the first temperature.

The first temperature may be lower than 341 K, and the second temperature may be higher than 341 K.

### [Advantageous Effects]

Embodiments of the present disclosure provide a variable resistance structure for which a simulation of an internal short circuit can be conducted, an electrode assembly including the variable resistance structure, a battery cell, a battery cell assembly, and a battery pack. The variable resistance structure is manufactured based on a transition metal oxide such as VO₂ and thus may provide a result of an internal short circuit test with high reproducibility and reliability.

Effects achievable from embodiments of the present disclosure are not limited to the above-described effects, and other effects that are not described herein will be clearly derived and understood by those of ordinary skill in the art to which the embodiments of the present disclosure pertain from the following description. That is, unintended effects achieved when the embodiments of the present disclosure are implemented are derivable by those of ordinary skill in the art from the embodiments of the present disclosure.

### [Brief Description of the Drawings]

FIG. 1 is a flowchart of a manufacturing method of a variable resistance structure according to embodiments.
FIG. 2 is a plan view for describing a manufacturing method of a variable resistance structure according to embodiments.
FIG. 3 is a side view of a workpiece of FIG. 2.
FIG. 4 is a plan view for describing a manufacturing method of a variable resistance structure according to embodiments.
FIG. 5 is a plan view of a variable resistance structure according to embodiments.
FIG. 6 is a side view of a variable resistance structure according to embodiments.
FIG. 7 is a cross-sectional view taken along line 5A-5A' of FIG. 5.
FIG. 8 is a flowchart of a manufacturing method of an electrode assembly according to embodiments.
FIG. 9 is a plan view of a positive electrode.
FIG. 10 is a side view of a positive electrode.
FIG. 11 is a plan view of a positive electrode and a separator.
FIG. 12 is a side view of a positive electrode and a separator.
FIG. 13 is a plan view of a positive electrode, a separator, and a variable resistance structure.
FIG. 14 is a side view of a positive electrode, a separator, and a variable resistance structure.
FIG. 15 is a plan view of an electrode assembly according to embodiments.
FIG. 16 is a side view of an electrode assembly according to embodiments.
FIG. 17 illustrates an electrode assembly according to other embodiments.
FIG. 18 illustrates an electrode assembly according to other embodiments.
FIG. 19 illustrates an electrode assembly according to other embodiments.
FIG. 20 is a cross-sectional view taken along line 19A-19A' of FIG. 19.
FIG. 21 is a cross-sectional view taken along line 19B-19B' of FIG. 19.
FIG. 22 is a cross-sectional view of a variable resistance structure.
FIG. 23 is a diagram illustrating a battery cell according to embodiments.
FIG. 24 is an exploded perspective view of a battery cell according to embodiments.
FIG. 25 is an exploded perspective view of a battery cell assembly according to embodiments.
FIG. 26 is a cross-sectional view taken along line 25A-25A' of FIG. 25.
FIG. 27 is a plan view of a battery pack according to embodiments.
FIG. 28 is a flowchart of an internal short circuit test method according to embodiments.

### [Best Mode]

Hereinafter, embodiments of the present disclosure will be described in detail with reference to the accompanying drawings. Before describing embodiments of the present disclosure, the terms or expressions used in the present specification and claims should not be construed as being limited to as generally understood or as defined in commonly used dictionaries, and should be understood according to meanings and concepts corresponding to the present disclosure on the basis of the principle that the inventor(s) of the application can appropriately define the terms or expressions to optimally explain the present disclosure.

Therefore, embodiments set forth herein and configurations illustrated in the drawings are only examples of the present disclosure and do not reflect all the technical ideas of the present disclosure and thus it should be understood that various equivalents and modifications that replace the configurations would have been made at the filing date of the present application.

Well-known configurations or functions related to describing the present disclosure are not described in detail when it is determined that they would obscure the subject matter of the present disclosure due to unnecessary detail.

Because embodiments of the present disclosure are provided to more fully explain the present disclosure to those of ordinary skill in the art, the shapes, sizes, etc. of components illustrated in the drawings may be exaggerated, omitted, or schematically illustrated for clarity. Therefore, it should not be understood that the sizes or proportions of components fully reflect the actual sizes or proportions thereof.

### (First and Second Embodiments)

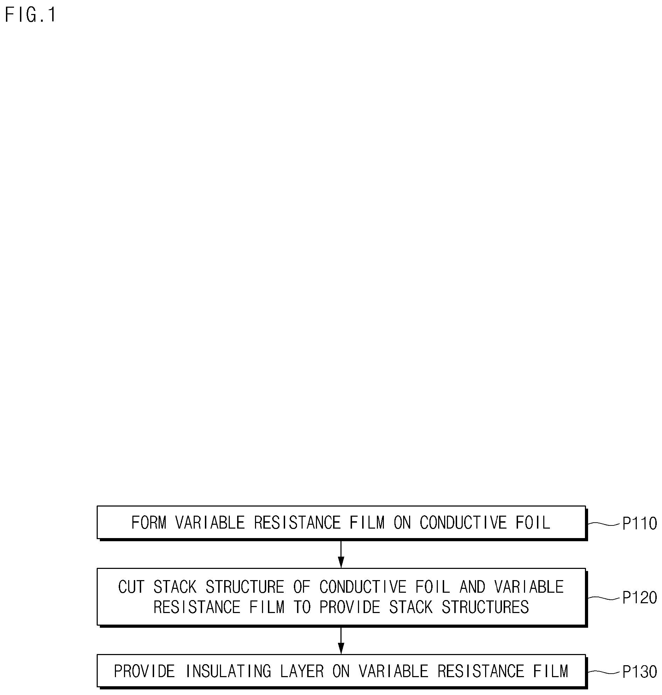

FIG. 1 is a flowchart of a manufacturing method of a variable resistance structure according to embodiments.

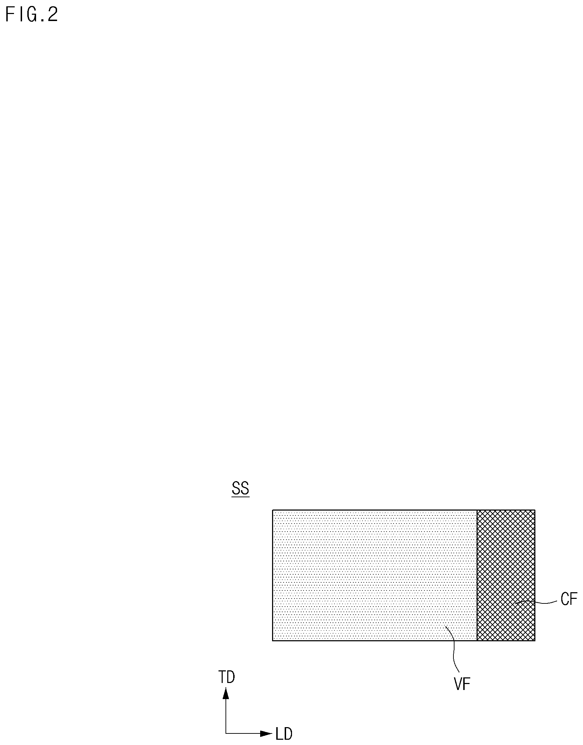

FIG. 2 is a plan view for describing the manufacturing method of a variable resistance structure according to embodiments.

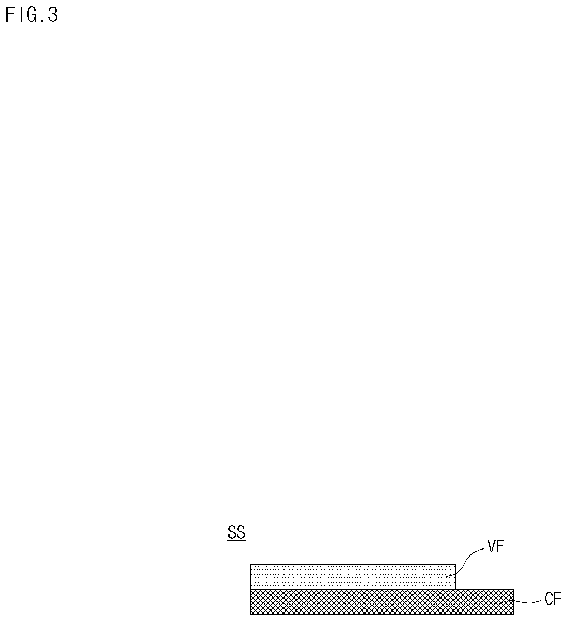

FIG. 3 is a side view of a workpiece of FIG. 2.

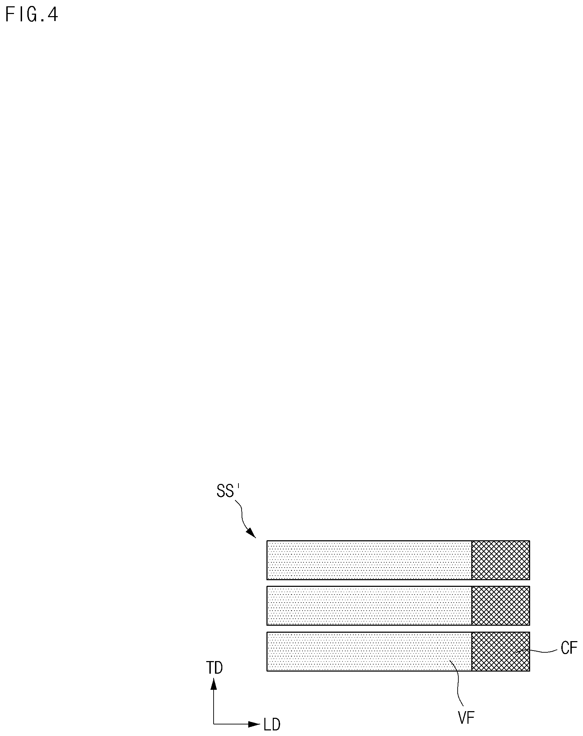

FIG. 4 is a plan view for describing the manufacturing method of a variable resistance structure according to embodiments.

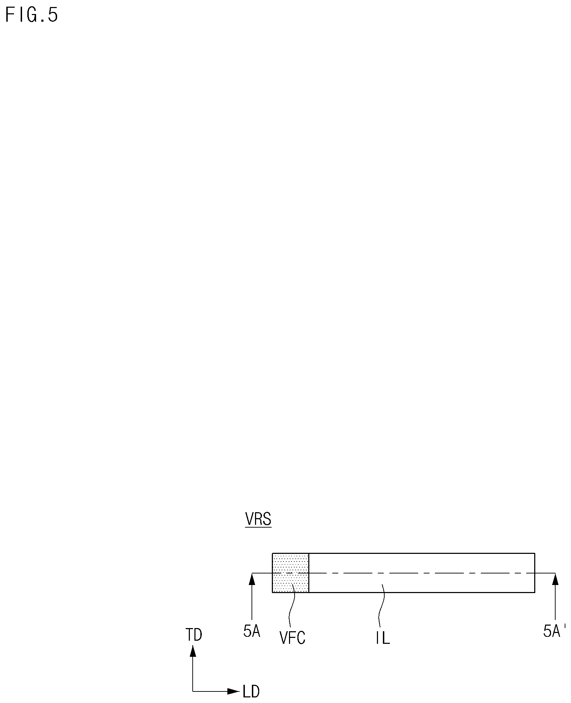

FIG. 5 is a plan view of a variable resistance structure VRS according to embodiments.

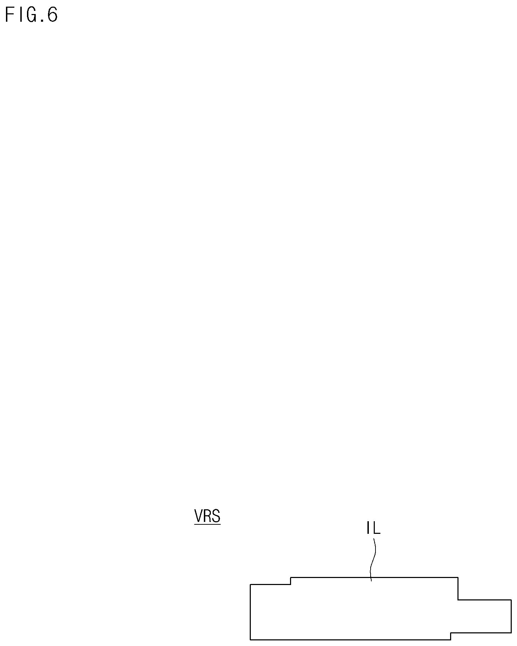

FIG. 6 is a side view of the variable resistance structure VRS according to embodiments.

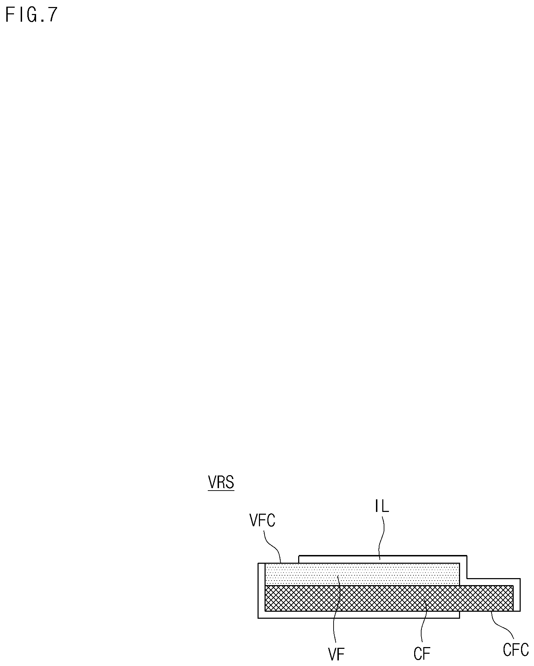

FIG. 7 is a cross-sectional view taken along line 5A-5A' of FIG. 5.

Referring to FIGS. 1 to 3, in P110, a variable resistance film VF may be formed on a conductive foil CF.

The conductive foil CF may include a conductive material. The conductive foil CF may include, for example, a metal. The conductive foil CF may include, for example, aluminum. The conductive foil CF may include, for example, copper. The conductive foil CF may include, for example, gold, silver, nickel, tungsten, iron, bronze, brass, a nickel alloy such as a nickel chromium alloy, silicon steel, a tungsten alloy, stainless steel, beryllium copper, or a tantalum alloy.

The variable resistance film VF may include a variable resistance material. The variable resistance material may have a resistivity characteristic (or conductance characteristic) that depends on temperature (i.e., that changes with temperature). The variable resistance material may be in a state of an insulator with a low conductance and a high resistivity at a temperature lower than a transition temperature and be in a state of a metal with a high conductance and a low resistivity at a temperature higher than the transition temperature.

According to embodiments, a conductance of the variable resistance material at a temperature higher than a transition temperature of the variable resistance material may be different from a conductance of the variable resistance material at a temperature lower than the transition temperature of the variable resistance material. According to embodiments, the conductance of the variable resistance material at a temperature higher than the transition temperature of the variable resistance material may be greater than the conductance of the variable resistance material at a temperature lower than the transition temperature of the variable resistance material.

According to the paper "Thermochromic VO2 thin films: A review on progress in solution processing methods" by D. Brassard, S. Fourmaux, and M. A. El Khakani (2010), which describes a change in resistance (or conductance) of a variable resistance material, a ratio of change of a resistance of VO₂ thin films may be in a range of 2 to 3 times or be about 100 times or more. A conductance and resistivity of a transition metal-based variable resistance material may vary according to a thickness, crystal structure, and doped state of a sample.

According to embodiments, the conductance of the variable resistance material at a temperature higher than the transition temperature of the variable resistance material may be about twice or more the conductance of the variable resistance material at a temperature lower than the transition temperature of the variable resistance material. According to embodiments, the conductance of the variable resistance material at a temperature higher than the transition temperature of the variable resistance material may be about three times or more the conductance of the variable resistance material at a temperature lower than the transition temperature of the variable resistance material. According to embodiments, the conductance of the variable resistance material at a temperature higher than the transition temperature of the variable resistance material may be about five times or less the conductance of the variable resistance material at a temperature lower than the transition temperature of the variable resistance material. According to embodiments, the conductance of the variable resistance material at a temperature higher than the transition temperature of the variable resistance material may be about four times or less the conductance of the variable resistance material at a temperature lower than the transition temperature of the variable resistance material.

According to embodiments, the conductance of the variable resistance material at a temperature higher than the transition temperature of the variable resistance material may be tens of times the conductance of the variable resistance material at a temperature lower than the transition temperature of the variable resistance material. According to embodiments, the conductance of the variable resistance material at a temperature higher than the transition temperature of the variable resistance material may be a hundred times or more the conductance of the variable resistance material at a temperature lower than the transition temperature of the variable resistance material.

According to embodiments, a resistivity of the variable resistance material at a temperature lower than the transition temperature of the variable resistance material may be different from a resistivity of the variable resistance material at a temperature higher than the transition temperature of the variable resistance material. According to embodiments, the resistivity of the variable resistance material at a temperature lower than the transition temperature of the variable resistance material may be greater than the resistivity of the variable resistance material at a temperature higher than the transition temperature of the variable resistance material.

According to embodiments, the resistivity of the variable resistance material at a temperature lower than the transition temperature of the variable resistance material may be about twice or more the resistivity of the variable resistance material at a temperature higher than the transition temperature of the variable resistance material. According to embodiments, the resistivity of the variable resistance material at a temperature lower than the transition temperature of the variable resistance material may be about three times or more the resistivity of the variable resistance material at a temperature higher than the transition temperature of the variable resistance material. According to embodiments, the resistivity of the variable resistance material at a temperature lower than the transition temperature of the variable resistance material may be about five times or less the resistivity of the variable resistance material at a temperature higher than the transition temperature of the variable resistance material. According to embodiments, the resistivity of the variable resistance material at a temperature lower than the transition temperature of the variable resistance material may be about four times or less the resistivity of the variable resistance material at a temperature higher than the transition temperature of the variable resistance material.

According to embodiments, the resistivity of the variable resistance material at a temperature lower than the transition temperature of the variable resistance material may be about tens of times the resistivity of the variable resistance material at a temperature higher than the transition temperature of the variable resistance material. According to embodiments, the resistivity of the variable resistance material at a temperature lower than the transition temperature of the variable resistance material may be about a hundred times or more the resistivity of the variable resistance material at a temperature higher than the transition temperature of the variable resistance material.

According to embodiments, the variable resistance film VF may include, for example, a transition metal oxide. The variable resistance film VF may include, for example, vanadium oxide such as VO₂ or V₂O₃, nickel oxide such as NiO, manganese oxide such as MnO, lanthanum calcium manganese oxide such as La₁₋ₓCaₓMnO₃, titanium oxide such as TiO₂, iron oxide such as Fe₃O₄, copper oxide such as Cu₂O, strontium ruthenium oxide such as SrRuO, ruthenium oxide such as RuO₂, iridium oxide such as IrO₂, or chromium oxide such as Cr₂O₃.

Among these oxides, a transition temperature of VO₂ is about 341 K (i.e., about 68 °C), which is relatively close to room temperature and thus a variable resistance characteristic can be easily used. In addition, VO₂ is more advantageous in terms of the formation of the variable resistance film VF due to a high transition rate between a metal state and an insulator state, reversible state transition, various tuning possibilities using doping and alloying, easiness of formation of a thin film, and thermodynamic safety.

Unlike VO₂, a transition temperature of V₂O₃ is about 150 K (i.e., about -123 °C). A transition temperature of nickel oxide is about 473K or higher, a transition temperature of manganese oxide is about 391K or higher, a transition temperature of lanthanum calcium manganese oxide is in a range of about 173K to about 473K, a transition temperature of iron oxide is 120K, a transition temperature of strontium ruthenium oxide is 80K, and a transition temperature of chromium oxide is about 673K. Pure titanium oxide does not exhibit a metal-insulator transition, and a transition temperature thereof is determined by doping. Transition temperatures of copper oxide, ruthenium oxide, and iridium oxide are not obvious.

The variable resistance film VF may be formed by, for example, liquid coating including spin coating, slot die coating, dipping coating, spray coating, and the like. The liquid coating may include applying an aqueous solution containing a variable resistance material, such as VO₂, to the conductive foil CF and performing a drying process to remove a solvent from the aqueous solution.

The variable resistance film VF may be formed by, for example, chemical vapor deposition (CVD) such as a plasma-enhanced CVD, low-pressure CVD, or atmospheric-pressure CVD. The variable resistance film VF may be formed by, for example, physical vapor deposition (PVD) such as evaporation, sputtering, and ion plating. The variable resistance film VF may be formed by sol-gel coating and a hydrothermal process.

The variable resistance film VF may partially cover the conductive foil CF. The variable resistance film VF may partially overlap the conductive foil CF. The variable resistance film VF may expose a portion of the conductive foil CF. The variable resistance film VF may expose an edge portion of the conductive foil CF in a longitudinal direction LD. Here, a length of the conductive foil CF in the longitudinal direction LD may be greater than a length of the conductive foil CF in a transverse direction TD. The longitudinal direction LD and the transverse direction TD may be substantially parallel to the conductive foil CF. The longitudinal direction LD and the transverse direction TD may be substantially perpendicular to each other.

Next, referring to FIGS. 1, 2, and 4, in P120, a stack structure SS of the conductive foil CF and the variable resistance film VF may be cut to provide a plurality of stack structures SS' whose width is less than a width of the stack structure SS. A plurality of stack structures SS' separated from each other in the transverse direction TD may be provided by cutting the stack structure SS. The conductive foil CF of each of the plurality of stack structures SS' may include a portion covered with the variable resistance film VF and a portion not covered with the variable resistance film VF (i.e., an exposed portion).

Next, referring to FIGS. 1, 5, 6 and 7, in P130, an insulating layer IL may be provided on the variable resistance film VF.

The insulating layer IL may include an insulating material. The insulating layer IL may include, for example, a separator. According to embodiments, the insulating layer IL may include polyolefin such as polypropylene and polyethylene. According to embodiments, the insulating layer IL may include polyolefin coated with alumina (Al₂O₃) or silica (SiO₂). According to embodiments, the insulating layer IL may include a cellulose-based separator. According to embodiments, the insulating layer IL may include polyimide, polyethylene terephthalate, polypropylene, polycarbonate, polyvinyl chloride, Teflon, ethylene-propylene-diene-monomer, silicon, polyethylene naphthalate, and aramid.

The insulating layer IL may be in contact with the conductive foil CF. The insulating layer IL may surround the conductive foil CF. The insulating layer IL may be in contact with the variable resistance film VF. The insulating layer IL may surround the variable resistance film VF.

The insulating layer IL may partially cover the conductive foil CF. The insulating layer IL may include a first opening exposing a contact portion CFC of the conductive foil CF. By adjusting a size of the first opening, an area of the contact portion CFC may be adjusted. The insulating layer IL may be configured to prevent a short circuit between an element outside the variable resistance structure VRS and a portion of the conductive foil CF excluding the contact portion CFC.

The insulating layer IL may partially cover the variable resistance film VF. The insulating layer IL may include a second opening exposing a contact portion VFC of the variable resistance film VF. By adjusting a size of the second opening, an area of the contact portion VFC may be adjusted. The insulating layer IL may be configured to prevent a short circuit between an element outside the variable resistance structure VRS and a portion of the variable resistance film VF excluding the contact portion VFC.

According to embodiments, the variable resistance structure VRS may implement a temperature-dependent short circuit between a first conductive element and a second conductive element. The first conductive element and the second conductive element may be short-circuited when a temperature of the variable resistance structure rises above the transition temperature while the contact portion CFC of the conductive foil CF is in contact with the first conductive element and the contact portion VFC of the variable resistance structure VRS is in contact with the second conductive element.

### (Third and Fourth Embodiments)

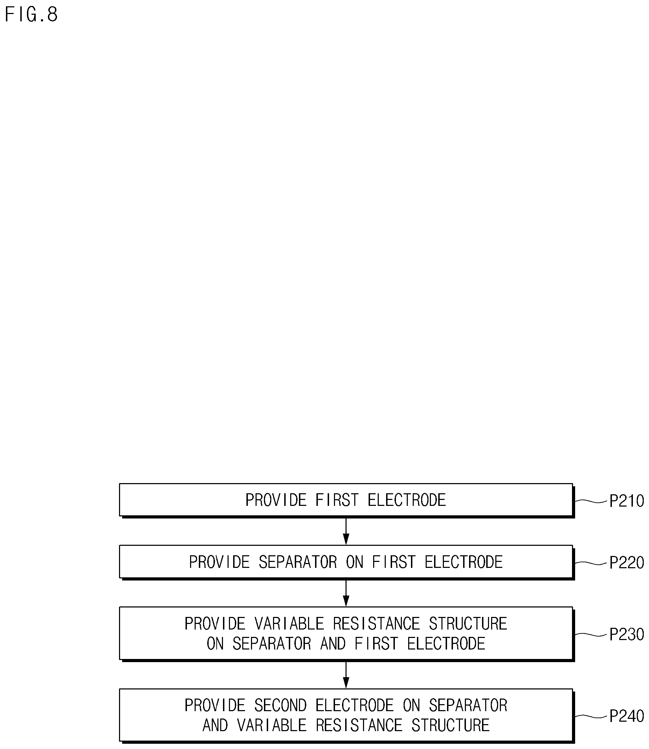

FIG. 8 is a flowchart of a manufacturing method of an electrode assembly according to embodiments.

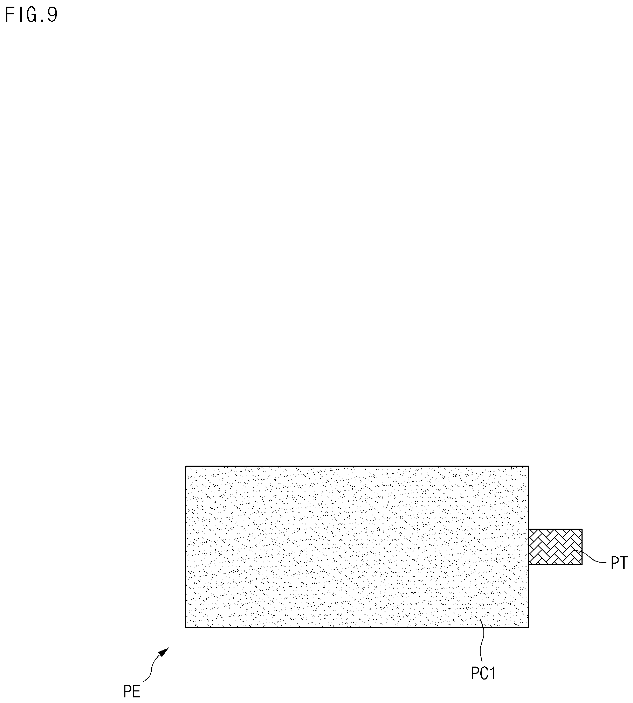

FIGS. 9 to 16 are diagrams for describing the manufacturing method of an electrode assembly according to embodiments, as will be described in detail below.

FIG. 9 is a plan view of a positive electrode PE.

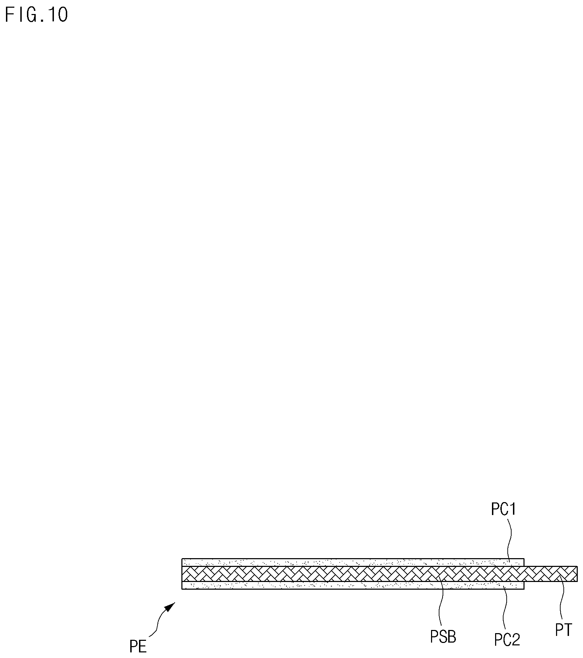

FIG. 10 is a side view of the positive electrode PE.

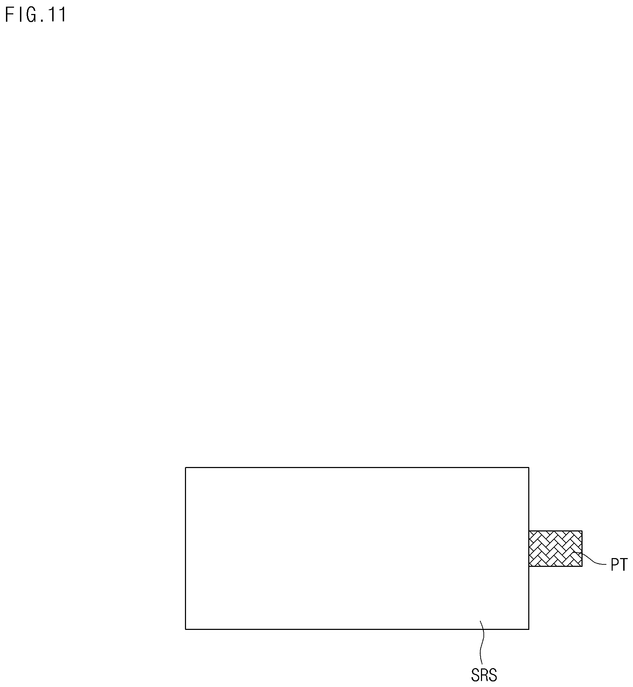

FIG. 11 is a plan view of the positive electrode PE (see FIG. 10) and a separator SRS.

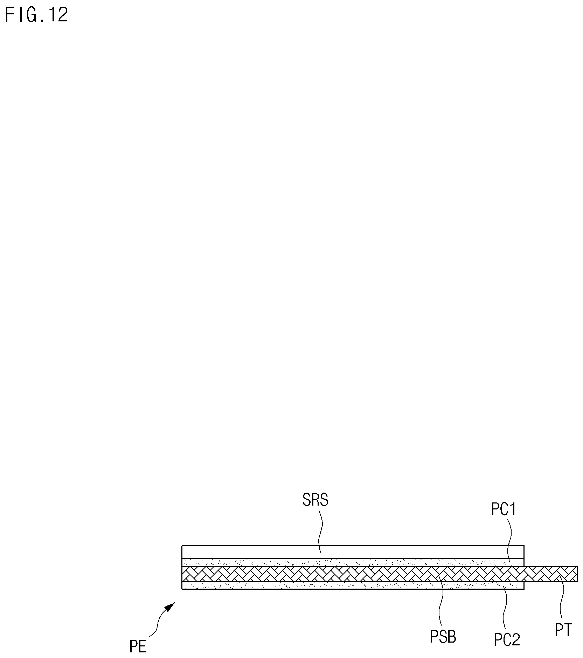

FIG. 12 is a side view of the positive electrode PE and the separator SRS.

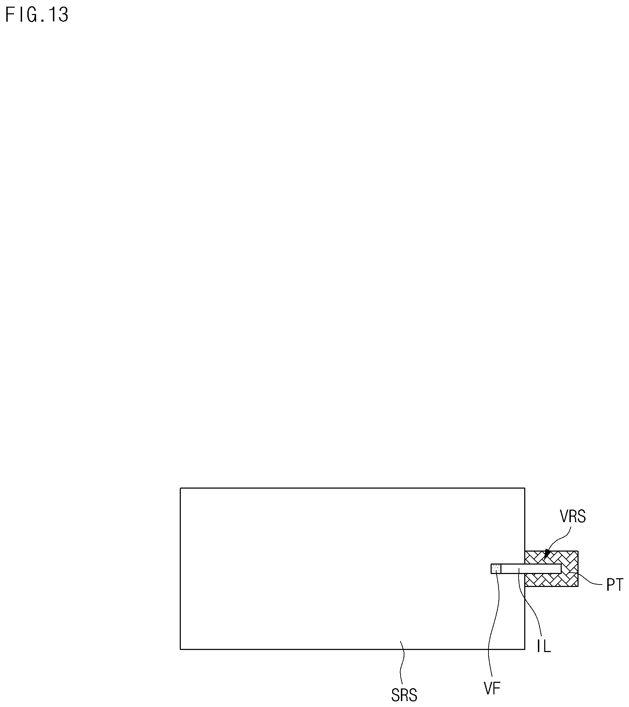

FIG. 13 is a plan view of the positive electrode PE (see FIG. 12), the separator SRS, and a variable resistance structure VRS.

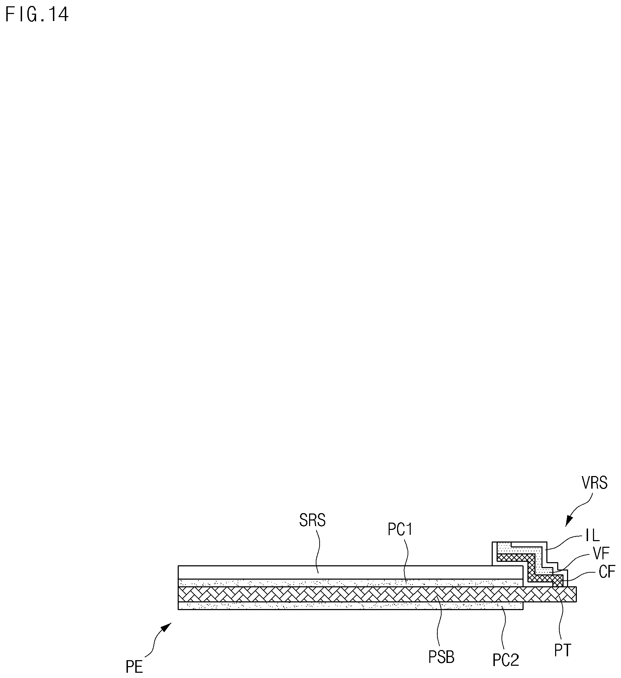

FIG. 14 is a side view of the positive electrode PE (see FIG. 12), the separator SRS, and the variable resistance structure VRS.

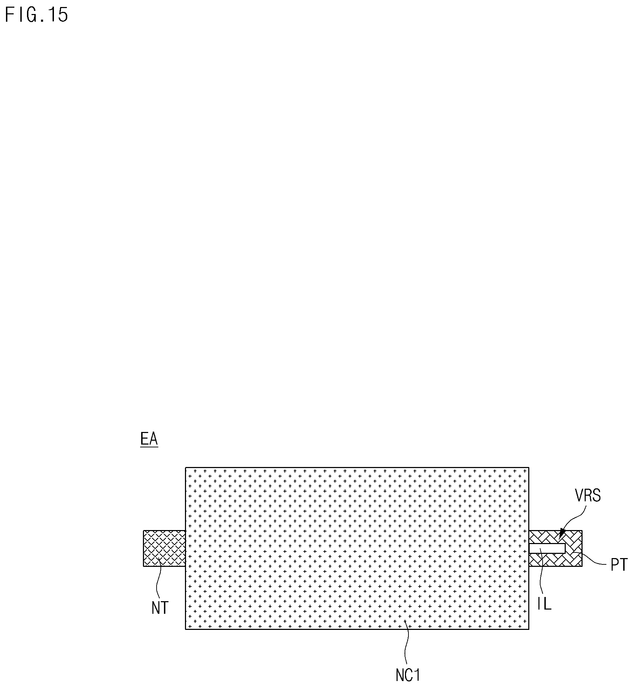

FIG. 15 is a plan view of an electrode assembly EA according to embodiments.

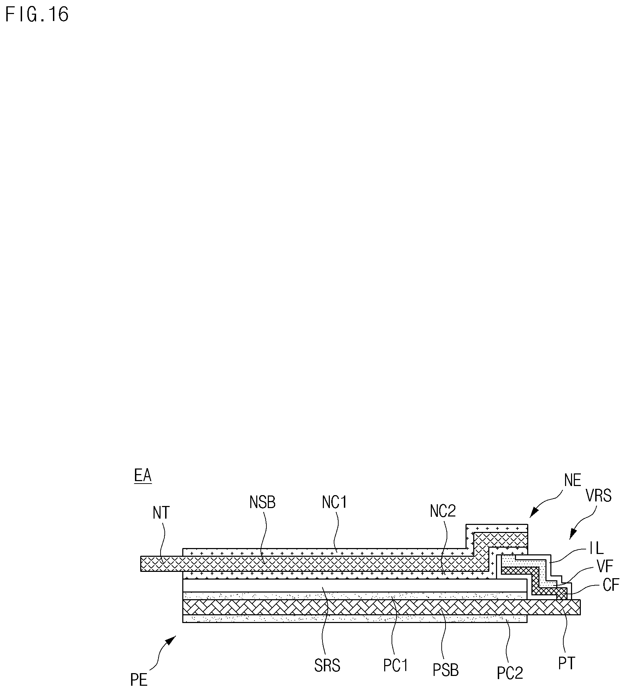

FIG. 16 is a side view of the electrode assembly EA according to embodiments.

Referring to FIGS. 8 to 10, in P210, the positive electrode PE may be provided. The positive electrode PE may be provided by a die coating process, a drying process, a roll pressing process, a slitting process, and a notching process. The positive electrode PE may include a positive electrode current collector PSB, a first positive electrode active material layer PC1, and a first positive electrode active material layer PC2.

A thickness of the positive electrode current collector PSB may range from about 3 µm to about 500 µm. The positive electrode current collector PSB may not cause a chemical change in a finally manufactured secondary battery and may have high conductivity. The positive electrode current collector PSB may include, for example, stainless steel, nickel, titanium, baked carbon, or aluminum. The positive electrode current collector PSB may include stainless steel surface-treated with carbon, nickel, titanium, silver, or the like. A surface of the positive electrode current collector PSB may include a fine uneven structure to increase the adhesion of an active material. The positive electrode current collector PSB may be in the form of a film, sheet, foil, net, porosity, foam or non-woven fabric.

The first positive electrode active material layer PC1 may be on a first surface of the positive electrode current collector PSB. The second positive electrode active material layer PC2 may be on a second surface of the positive electrode current collector PSB. The first surface and the second surface of the positive electrode current collector PSB are opposite to each other. The first positive electrode active material layer PC1 and the second positive electrode active material layer PC2 may include, for example, a positive electrode active material.

The positive electrode active material is a material that may cause an electrochemical reaction. The positive electrode active material may be a lithium transition metal oxide. For example, the positive electrode active material may include: a layered compound substituted with one or more transition metal, e.g., lithium cobalt oxide (LiCoO₂) or lithium nickel oxide (LiNiO₂); lithium manganese oxide substituted with one or more transition metal; lithium nickel-based oxide expressed by a chemical formula of LiNi_{1-y}M_{y}O₂ (here, M is Co, Mn, Al, Cu, Fe, Mg, B, Cr, Zn or Ga, and 0.01≤y≤0.7); lithium nickel cobalt manganese compound oxide expressed by a chemical formula of Li_{1+z}Ni_{b}Mn_{c}Co_{1-(b+c+d)}M_{d}O₍₂₋ₑ₎A, e.g., Li_{1+z}Ni_{1/3}Co_{1/3}Mn_{1/3}O₂ or Li_{1+z}Ni_{0.4}Mn_{0.4}Co_{0.2}O₂ (here, -0.5≤z≤0.5, 0.1≤b≤0.8, 0.1≤c≤0.8, 0≤d≤0.2, 0≤e≤0.2, b+c+d<1, M is Al, Mg, Cr, Ti, Si or Y, and A is F, P or Cl); or olivine-based lithium metal phosphate expressed by a chemical formula of Li₁₊ₓM_{1-y}M'_{y}PO_{4-z}X_{z} (here, M is a transition metal, and more particularly, Fe, Mn, Co or Ni, M' is Al, Mg or Ti, X is F, S or N, -0.5≤x≤+0.5, 0≤y≤0.5, and 0≤z≤0.1).

A portion of the positive electrode current collector PSB to which the first positive electrode active material layer PC1 and the second positive electrode active material layer PC2 are applied (i.e., which overlaps the first positive electrode active material layer PC1 and the second positive electrode active material layer PC2) may be referred to as a coated portion, and a portion of the positive electrode current collector PSB to which the first positive electrode active material layer PC1 and the second positive electrode active material layer PC2 are not applied (i.e., which is spaced apart from the first positive electrode active material layer PC1 and the second positive electrode active material layer PC2) may be referred to as an uncoated portion. The uncoated portion of the positive electrode current collector PSB may be a positive electrode tab PT of the positive electrode current collector PSB. The positive electrode tab PT may be an external connection terminal of the positive electrode PE. A width of the positive electrode tab PT may be less than a width of each of the first positive electrode active material layer PC1 and the second positive electrode active material layer PC2.

Next, referring to FIGS. 8, 11, and 12, the separator SRS may be provided on the positive electrode PE. According to embodiments, the separator SRS may include polyolefin such as polypropylene and polyethylene. According to embodiments, the separator SRS may include polyolefin coated with alumina (Al₂O₃) or silica (SiO₂). According to embodiments, the separator SRS may include a cellulose-based separator.

The separator SRS may cover the first positive electrode active material layer PC1. The separator SRS may have a larger area than an area of the first positive electrode active material layer PC1 to prevent a short circuit between the positive electrode PE and a subsequent negative electrode NE (see FIG. 16). A width of the separator SRS may be greater than a width of the first positive electrode active material layer PC1. A length of the separator SRS may be greater than a length of the first positive electrode active material layer PC 1.

Next, referring to FIGS. 7, 8, 13, and 14, the variable resistance structure VRS may be provided on the separator SRS and the positive electrode PE. The variable resistance structure VRS may be provided by the method described above with reference to FIGS. 1 to 7.

According to embodiments, a conductive foil CF of the variable resistance structure VRS may face the positive electrode PE (more specifically, the positive electrode tab PT). According to embodiments, the contact portion CFC of the conductive foil CF of the variable resistance structure VRS may be in contact with the positive electrode PE (more specifically, the positive electrode tab PT).

According to embodiments, the conductive foil CF of the variable resistance structure VRS may be fixed to the positive electrode PE (more specifically, the positive electrode tab PT) via an adhesive. The adhesive may be partially provided between the conductive foil CF and the positive electrode tab PT so as not to impair a short circuit between the conductive foil CF and the positive electrode tab PT. That is, an area of the positive electrode tab PT to which the adhesive is applied may be less than an area of the conductive foil CF in contact with the positive electrode tab PT.

The variable resistance film VF may be spaced apart from the positive electrode tab PT with the conductive foil CF therebetween. The variable resistance film VF may not be in contact with the positive electrode tab PT. A stack structure of the positive electrode PE and the separator SRS may be transferred to the variable resistance structure VRS. Accordingly, the variable resistance structure VRS may include a step shape.

Next, with reference to FIGS. 7, 8, 15, and 16, a negative electrode NE may be provided on the separator SRS and the variable resistance structure VRS. The negative electrode NE may be provided by a die coating process, a drying process, a roll pressing process, a slitting process, and a notching process. The negative electrode NE may include a negative electrode current collector NSB, a first negative electrode active material layer NC1, and a second negative electrode active material layer NC2.

A thickness of the negative electrode current collector NSB may be in a range of about 3 µm to about 500 µm. The negative electrode current collector NSB may not cause a chemical change in a finally manufactured secondary battery and may have high conductivity. The negative electrode current collector NSB may include copper, stainless steel, aluminum, nickel, titanium, baked carbon, or an aluminum-cadmium alloy. The negative electrode current collector NSB may include stainless steel surface-treated with carbon, nickel, titanium, silver, or the like. A surface of the negative electrode current collector NSB may include a fine uneven structure to increase the adhesion of an active material. The negative electrode current collector NSB may be in the form of a film, sheet, foil, net, porosity, foam or non-woven fabric.

The first negative electrode active material layer NC1 may be on a first surface of the negative electrode current collector NSB. The second negative electrode active material layer NC2 may be on a second surface of the negative electrode current collector NSB. The first surface and the second surface of the negative electrode current collector NSB are opposite to each other. The first negative electrode active material layer NC1 and the second negative electrode active material layer NC2 may include, for example, a negative electrode active material.

The negative electrode active material may include, for example, carbon such as non-graphitized carbon or graphite-based carbon. The negative electrode active material may include, for example, a metal composite oxide such as LiₓFe₂O₃ (0≤x≤1), LixWO₂ (0≤x≤1), or SnₓMe₁₋ₓMe'_{y}O_{z} (here, Me is Mn, Fe, Pb, or Ge, Me' is Al, B, P, Si, a Group I element, a Group II element or a Group III element of the periodic table, or halogen, 0<x≤1, 1≤y≤3, and 1≤z≤8). The negative electrode active material may include, for example, lithium metal, lithium alloy, silicon-based alloy, or tin-based alloy. The negative electrode active material may include, for example, a metal oxide such as SnO, SnO₂, PbO, PbO₂, Pb₂O₃, Pb₃O₄, Sb₂O₃, Sb₂O₄, Sb₂O₅, GeO, GeO₂, Bi₂O₃, Bi₂O₄, or Bi₂O₅. The negative electrode active material may include, for example, a conductive polymer such as polyacetylene, a Li-Co-Ni-based material, etc.

A portion of the negative electrode current collector NSB to which the first negative electrode active material layer NC1 and the second negative electrode active material layer NC2 are applied (i.e., which overlaps the first negative electrode active material layer NC1 and the second negative electrode active material layer NC2) may be referred to as a coated portion, and a portion of the negative electrode current collector NSB to which the first negative electrode active material layer NC 1 and the second negative electrode active material layer NC2 are not applied (i.e., which is spaced apart from the first negative electrode active material layer NC1 and the second negative electrode active material layer NC2) may be referred to as an uncoated portion. The uncoated portion of the negative electrode current collector NSB may be a negative electrode tab NT of the negative electrode current collector NSB. The negative electrode tab NT may be an external connection terminal of the negative electrode NE. A width of the negative electrode tab NT may be less than a width of each of the first negative electrode active material layer NC1 and the second negative electrode active material layer NC2.

According to embodiments, the second negative electrode active material layer NC2 may face the insulating layer IL and the variable resistance film VF. According to embodiments, the second negative electrode active material layer NC2 may be in contact with the insulating layer IL and the variable resistance film VF. According to embodiments, the second negative electrode active material layer NC2 may be in contact with the contact portion VFC of the variable resistance film VF. The variable resistance structure VRS may include a portion on the positive electrode tab PT and a portion between the negative electrode NE and the separator SRS.

The second negative electrode active material layer NC2 may be spaced apart from the conductive foil CF with at least one of the insulating layer IL and the variable resistance film VF interposed therebetween. Accordingly, a short circuit between the second negative electrode active material layer NC2 and the conductive foil CF may be prevented, and insulation between the positive electrode PE and the negative electrode NE may be maintained before a temperature of the variable resistance film VF is raised above the transition temperature for a short circuit test. When the temperature of the variable resistance film VF is raised above the transition temperature, a short circuit path including the second negative electrode active material layer NC2, the variable resistance film VF, the conductive foil CF, and the positive electrode tab PT may be provided.

### (Fifth Embodiment)

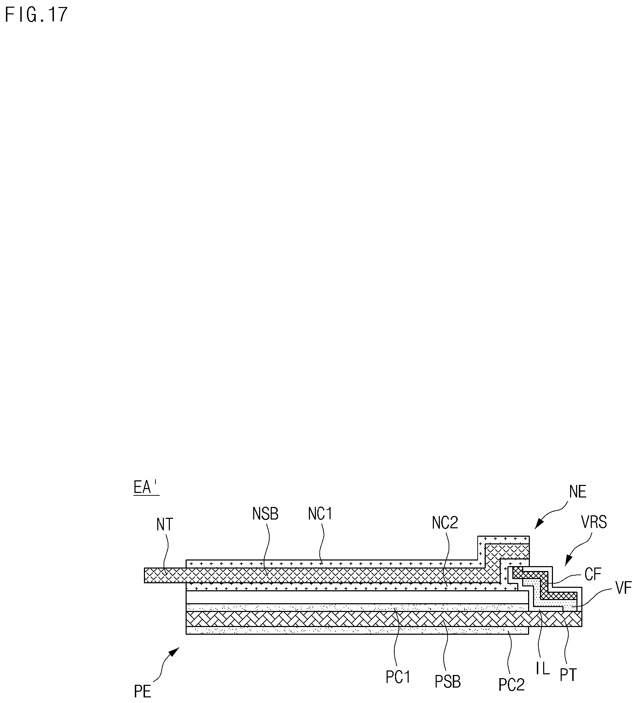

FIG. 17 is a side view of an electrode assembly EA' according to embodiments.

Referring to FIGS. 7 and 17, the electrode assembly EA' may include a positive electrode PE, a negative electrode NE, a separator SRS, and a variable resistance structure VRS.

The electrode assembly EA' is substantially the same as the electrode assembly EA of FIG. 16 except for an orientation of the variable resistance structure VRS. The variable resistance structure VRS of the electrode assembly EA' may include a portion on the positive electrode tab PT and a portion between the negative electrode NE and the separator SRS. A stack structure of the positive electrode PE and the separator SRS may be transferred to the variable resistance structure VRS. Accordingly, the variable resistance structure VRS may include a step shape.

According to embodiments, the positive electrode tab PT may face an insulating layer IL and a variable resistance film VF. According to embodiments, the positive electrode tab PT may be in contact with the insulating layer IL and the variable resistance film VF. According to embodiments, the positive electrode tab PT may be in contact with a contact portion VFC (see FIG. 5) of the variable resistance film VF.

According to embodiments, the variable resistance film VF may be fixed to the positive electrode PE (more specifically, the positive electrode tab PT) via an adhesive. The adhesive may be partially provided between the variable resistance film VF and the positive electrode tab PT so as not to inhibit a short circuit between the variable resistance film VF and the positive electrode tab PT when the variable resistance film VF is in a metal state. That is, an area of the positive electrode tab PT to which the adhesive is applied may be less than an area of the variable resistance film VF in contact with the positive electrode tab PT.

According to embodiments, the conductive foil CF of the variable resistance structure VRS may face the second negative electrode active material layer NC2. According to embodiments, the contact portion CFC of the conductive foil CF may be in contact with the second negative electrode active material layer NC2.

The positive electrode tab PT may be spaced apart from the conductive foil CF with at least one of the insulating layer IL and the variable resistance film VF interposed therebetween. Accordingly, a short circuit between the positive electrode tab PT and the conductive foil CF may be prevented, and insulation between the positive electrode PE and the negative electrode NE may be maintained before a temperature of the variable resistance film VF is raised above the transition temperature for a short circuit test. When the temperature of the variable resistance film VF is raised above the transition temperature, a short-circuit path including the second negative electrode active material layer NC2, the conductive foil CF, the variable resistance film VF, and the positive electrode tab PT may be provided.

### (Sixth Embodiment)

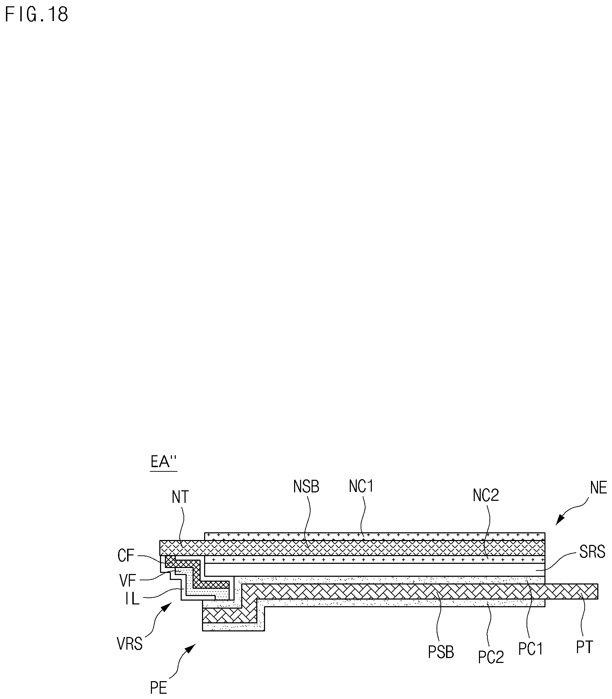

FIG. 18 is a side view of an electrode assembly EA" according to embodiments.

Referring to FIGS. 7 and 18, the electrode assembly EA" may include a positive electrode PE, a negative electrode NE, a separator SRS, and a variable resistance structure VRS.

The electrode assembly EA" is substantially the same as the electrode assembly EA of FIG. 16 except for a position of the variable resistance structure VRS. The variable resistance structure VRS of the electrode assembly EA" may include a portion on the negative electrode tab NT and a portion between the positive electrode PE and the separator SRS. A stack structure of the negative electrode PE and the separator SRS may be transferred to the variable resistance structure VRS. Accordingly, the variable resistance structure VRS may include a step shape.

According to embodiments, the first positive electrode active material layer PC1 may face an insulating layer IL and a variable resistance film VF. According to embodiments, the first positive electrode active material layer PC1 may be in contact with the insulating layer IL and the variable resistance film VF. According to embodiments, the first positive electrode active material layer PC1 may be in contact with a contact portion VFC of the variable resistance film VF.

According to embodiments, a conductive foil CF of the variable resistance structure VRS may face the negative electrode NE (more specifically, a negative electrode tab NT). According to embodiments,, a contact portion CFC of the conductive foil CF may be in contact with the negative electrode NE (more specifically, the negative electrode tab NT).

According to embodiments, the conductive foil CF of the variable resistance structure VRS may be fixed to the negative electrode NE (more specifically, the negative electrode tab NT) via an adhesive. The adhesive may be partially provided between the conductive foil CF and the negative electrode tab NT so as not to impair a short circuit between the conductive foil CF and the negative electrode tab NT. That is, an area of the negative electrode tab NT to which the adhesive is applied may be less than an area of the conductive foil CF in contact with the negative electrode tab NT. The variable resistance film VF may be spaced apart from the negative electrode tab NT with the conductive foil CF therebetween. The variable resistance film VF may not be in contact with the negative electrode tab NT.

The first positive electrode active material layer PC1 may be spaced apart from the conductive foil CF with at least one of the insulating layer IL and the variable resistance film VF interposed therebetween. Accordingly, a short circuit between the first positive electrode active material layer PC1 and the conductive foil CF may be prevented, and insulation between the positive electrode PE and the negative electrode NE may be maintained before a temperature of the variable resistance film VF is raised above the transition temperature for a short circuit test. When the temperature of the variable resistance film VF is raised above the transition temperature, a short circuit path including the first positive electrode active material layer PC1, the variable resistance film VF, the conductive foil CF, and the negative electrode tab NT may be provided.

### (Seventh Embodiment)

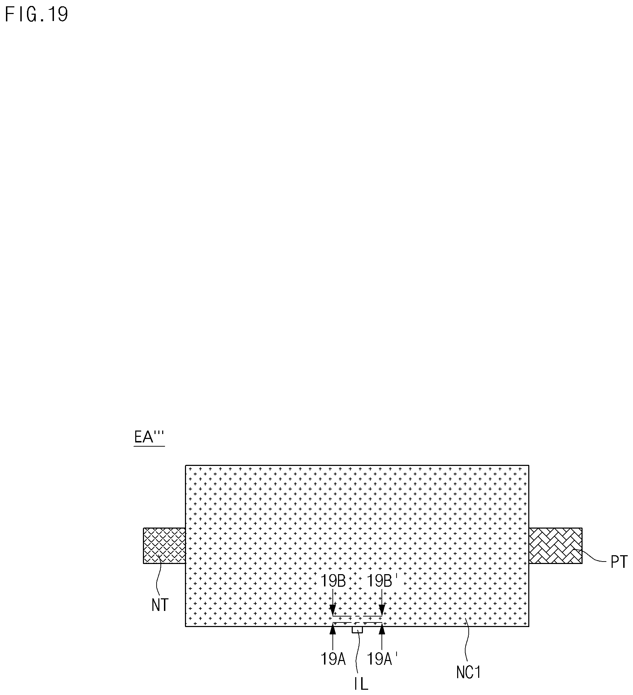

FIG. 19 is a plan view of an electrode assembly EA"' according to embodiments.

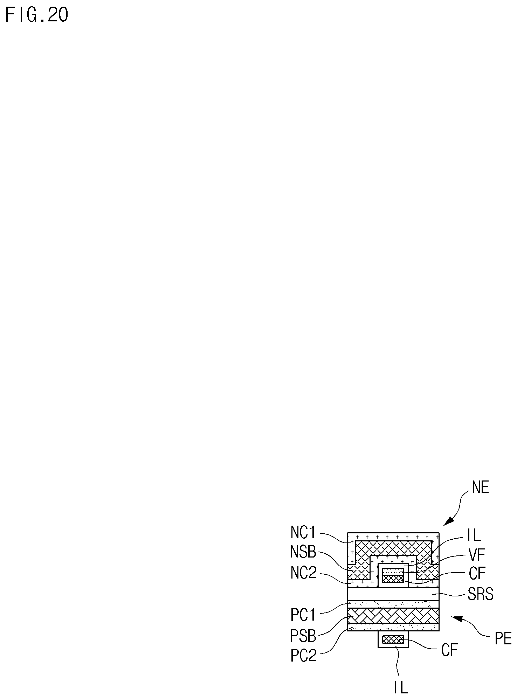

FIG. 20 is a cross-sectional view taken along line 19A-19A' of FIG. 19.

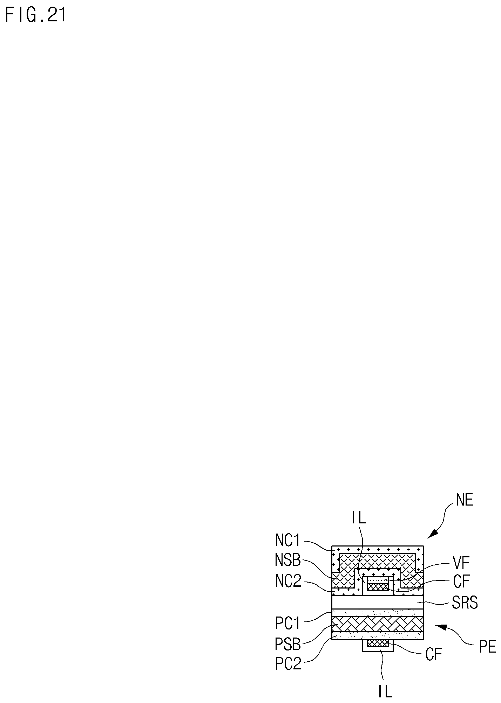

FIG. 21 is a cross-sectional view taken along line 19B-19B' of FIG. 19.

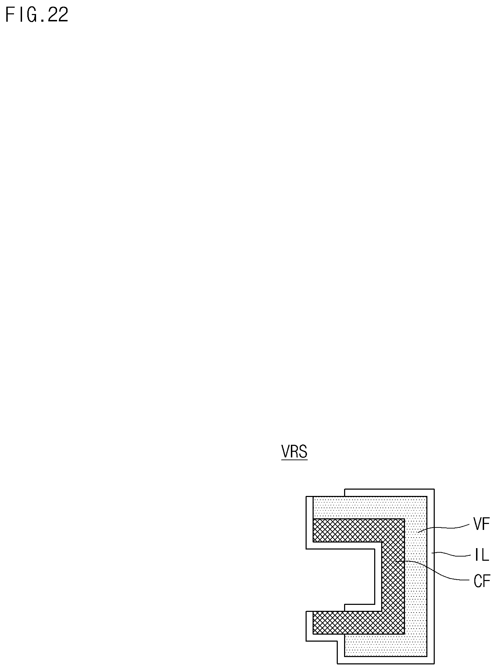

FIG. 22 is a front view of a variable resistance structure according to embodiments.

Referring to FIGS. 7 and 19 to 22, the electrode assembly EA"' may include a positive electrode PE, a negative electrode NE, a separator SRS, and a variable resistance structure VRS.

The electrode assembly EA"' is substantially the same as the electrode assembly EA of FIG. 16 except for a position of the variable resistance structure VRS. The variable resistance structure VRS may be spaced apart from a positive electrode tab PT. The variable resistance structure VRS may not overlap the positive electrode tab PT. The variable resistance structure VRS may overlap edges of the positive electrode PE. The variable resistance structure VRS may be spaced apart from a negative electrode tab NT. The variable resistance structure VRS may not overlap the negative electrode tab NT. The variable resistance structure VRS may overlap an edge of the negative electrode NE.

That is, in the embodiments of FIGS. 16 to 18, the variable resistance structure VRS is on end portions of the positive electrode PE and the negative electrode NE in the longitudinal direction (or in a direction in which the positive electrode tab PT and the negative electrode tab NT protrude), whereas in the example of FIG. 19, the variable resistance structure VRS may overlap edges of the positive electrode PE and the negative electrode NE parallel to the longitudinal direction (or to a direction in which the positive electrode tab PT and the negative electrode tab NT protrude).

According to embodiments, the variable resistance structure VRS may be bent in a roughly C-shape. According to embodiments, the variable resistance structure VRS of the electrode assembly EA"' may include a portion between the negative electrode NE and the separator SRS. The portion of the variable resistance structure VRS between the negative electrode NE and the separator SRS may not be separated from the negative electrode NE even when an adhesive is not used. The variable resistance structure VRS may include a portion on a second positive electrode active material layer PC2. The portion of the variable resistance structure VRS on the second positive electrode active material layer PC2 may be fixed to the second positive electrode active material layer PC2 via an adhesive or by stacking an additional separator.

According to embodiments, the conductive foil CF may face the second positive electrode active material layer PC2 of the positive electrode PE. According to embodiments, a contact portion CFC of the conductive foil CF may be in contact with the second positive electrode active material layer PC2 of the positive electrode PE. An insulating layer IL may include a portion between the conductive foil CF and the second positive electrode active material layer PC2.

The conductive foil CF may not be in contact with a second negative electrode active material layer NC2 of the negative electrode NE. The conductive foil CF may be spaced apart from the second negative electrode active material layer NC2 with at least one of the insulating layer IL and the variable resistance film VF interposed therebetween. The conductive foil CF may include a first portion interposed between the separator SRS and the negative electrode NE and spaced apart from the second negative electrode active material layer NC2 of the negative electrode NE with the insulating layer IL and the variable resistance film VF therebetween. The conductive foil CF may include a second portion interposed between the separator SRS and the negative electrode NE and spaced apart from the second negative electrode active material layer NC2 of the negative electrode NE with only the variable resistance film VF therebetween.

According to embodiments, the variable resistance film VF may face the second negative electrode active material layer NC2 of the negative electrode NE. According to embodiments, a contact portion VFC of the variable resistance film VF may be in contact with the second negative electrode active material layer NC2 of the negative electrode NE.

A short circuit between the second negative electrode active material layer NC2 and the conductive foil CF at a temperature below the transition temperature may be prevented by at least one of the insulating layer IL and the variable resistance film VF. When a temperature of the variable resistance film VF increases to the transition temperature or higher, a short-circuit path including a first positive electrode active material layer PC1, the conductive foil CF, the variable resistance film VF and the second negative electrode active material layer NC2 may be provided.

### (Eighth Embodiment)

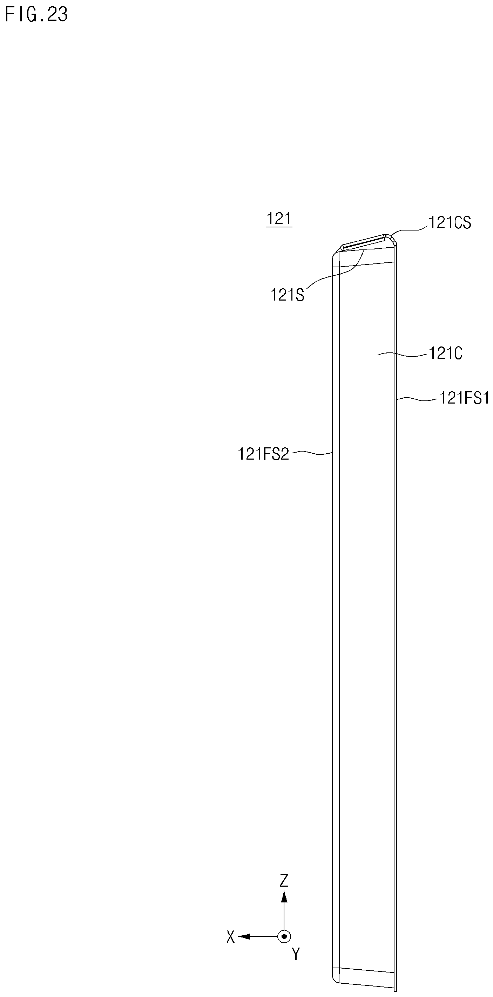

FIG. 23 is a side view of a battery cell 121 according to embodiments.

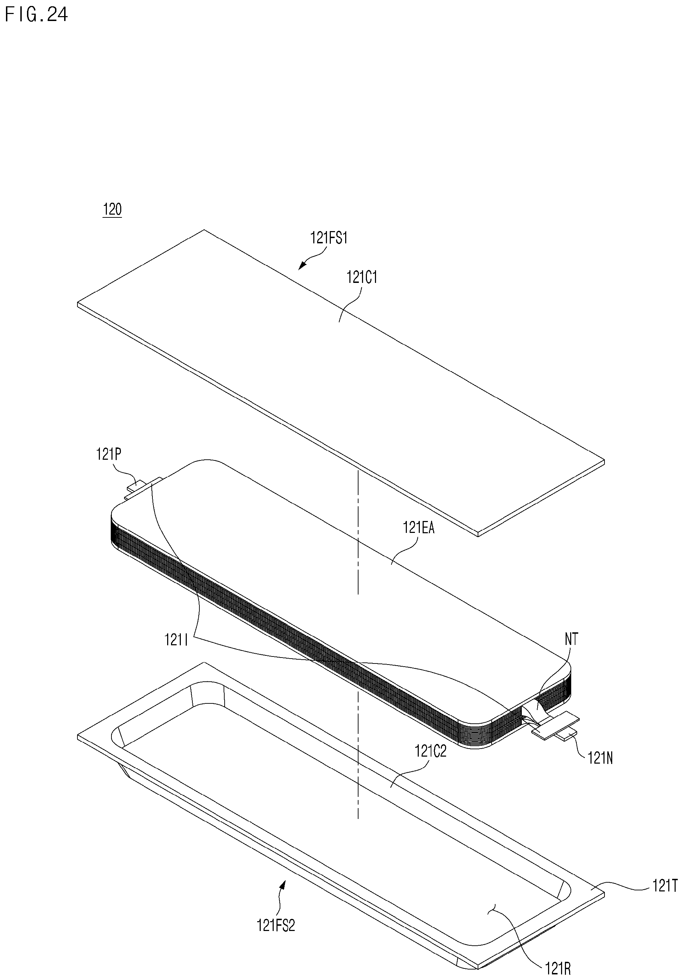

FIG. 24 is an exploded perspective view of the battery cell 121 according to embodiments.

Referring to FIGS. 16, 23 and 24, the battery cell 121 may include a cell case 121C, an electrode assembly 121EA, a positive electrode terminal 121P, and a negative electrode terminal 121N. The battery cell 121 may further include an electrolyte.

According to embodiments, the battery cell 121 may be a cylindrical battery cell, a prismatic battery cell, or a pouch type battery cell. An electrode assembly of the cylindrical battery cell is embedded in a cylindrical metal can. An electrode assembly of the prismatic battery cell is embedded in a prismatic metal can. An electrode assembly of the pouch type battery cell is embedded in a pouch case including an aluminum laminate sheet. Hereinafter, the technical idea of the present disclosure will be described with respect to an example in which the battery cell 121 is a pouch type battery cell but those of ordinary skill in the art will be able to easily derive an example in which the battery cell 121 is a cylindrical battery cell or a prismatic battery cell based on the description herein.

The electrode assembly 121EA may be provided based on the electrode assembly EA of FIG. 16. More specifically, the electrode assembly 121EA may be provided by stacking additional positive electrodes PE (see FIG. 16), additional negative electrodes PE (see FIG. 16), and additional separators SRS (see FIG. 16) in the electrode assembly EA. The electrode assembly 121EA may be provided by stacking additional positive electrodes PE (see FIG. 16), additional negative electrodes PE (see FIG. 16), and additional separators SRS (see FIG. 16) on the electrode assemblies EA', EA" and EA"' of FIGS. 17, 18 and 19 instead of the electrode assembly EA of FIG. 16.

Accordingly, the electrode assembly 121EA may include a plurality of positive electrodes PE, a plurality of negative electrodes NE, a plurality of separators SRS between neighboring ones of the plurality of positive electrodes PE and the plurality of negative electrodes NE, and a variable resistance structure VRS in contact with one of the plurality of positive electrodes PE and one of the plurality of negative electrodes NE. The electrode assembly 121EA may include only one variable resistance structure VRS or two or more variable resistance structures VRS.

Each of the plurality of positive electrodes PE of the electrode assembly 121EA may include a positive electrode tab PT. The positive electrode tab PT of each of the plurality of positive electrodes PE of the electrode assembly 121EA may be short-circuited with the positive electrode terminal 121P. The positive electrode tab PT of each of the plurality of positive electrodes PE of the electrode assembly 121EA may be welded to the positive electrode terminal 121P.

Each of the plurality of negative electrodes NE of the electrode assembly 121EA may include a negative electrode tab NT. The negative electrode tab NT of each of the plurality of negative electrodes NE of the electrode assembly 121EA may be short-circuited with the negative electrode terminal 121N. The negative electrode tab NT of each of the plurality of negative electrodes NE of the electrode assembly 121EA may be welded to the negative electrode terminal 121N.

The cell case 121C may include an inner resin layer, a metal layer, and an outer resin layer. An adhesive and an anti-corrosion layer may be further provided between the inner resin layer and the metal layer and between the outer resin layer and the metal layer.

The inner resin layer may have thermal adhesion and be referred to as a sealant layer. The inner resin layer allows sealing of the cell case 121C. The inner resin layer may include, for example, a polyolefin-based resin such as polypropylene and polyethylene. The metal layer may include an alloy of iron, carbon, chromium and manganese, an alloy of iron, chromium and nickel, or aluminum. The metal layer may be a gas barrier. The metal layer may block the entry and exit of a gas from the cell case 121C. The outer resin layer may be a surface protective layer. The outer resin layer may include a material having wear resistance and heat resistance, such as a nylon resin.

The cell case 121C may be provided by bonding a first cell case 121C1 and a second cell case 121C2 together. The first cell case 121C1 may be substantially flat. The first cell case 121C1 may not include a receiving part. The second cell case 121C2 may include a receiving part 121R. The receiving part 121R may be formed by a pouch forming process. The receiving part 121R is a part of the second cell case 121C2 that is molded in the form of bowl to accommodate the electrode assembly 121EA therein.

A terrace 121T of the second cell case 121C2 may surround the receiving part 121R. The terrace 121T of the second cell case 121C2 may be bonded to an edge of the first cell case 121C1 to form the cell case 121C. A sealing part 121CS may be provided by bonding the first and second cases 121C1 and 121C2 together. That is, the sealing part 121CS may be a bonding part of the first and second cases 121C1 and 121C2.

As illustrated in FIG. 2, when a receiving part is formed in only the second cell case 121C2 among the first and second cases 121C1 and 121C2, the sealing part 121CS may be connected to a first main surface 121FS1. The sealing part 121CS may include a portion that is coplanar with the first main surface 121FS1.

The cell case 121C may have a roughly rectangular parallelepiped shape, and the first main surface 121FS1 and a second main surface 121FS2 of the cell case 121C may be widest surfaces of the cell case 121C. The first main surface 121FS1 and the second main surface 121FS2 may be substantially parallel to the electrode assembly 121EA or at least one of the plurality of positive electrodes and the plurality of negative electrodes of the electrode assembly 121EA. The first main surface 121FS1 and the second main surface 121FS2 may be opposite to each other. The first main surface 121FS1 and the second main surface 121FS2 may be substantially perpendicular to an X-axis direction but embodiments are not limited thereto.

An insulating tape 121I may be applied onto the positive electrode terminal 121P and the negative electrode terminal 121N. The positive electrode terminal 121P and the negative electrode terminal 121N may protrude to the outside of the cell case 121C. The positive electrode terminal 121P and the negative electrode terminal 121N may protrude from the cell case 121C in a Y-axis direction. Accordingly, a resulting voltage and current of the battery cell 121 may be output through the positive electrode terminal 121P and the negative electrode terminal 121N. The positive electrode terminal 121P may be a positive electrode lead. The negative electrode terminal 121N may be a negative electrode lead. The Y-axis direction may be substantially perpendicular to an X-axis direction.

### (Ninth Embodiment)

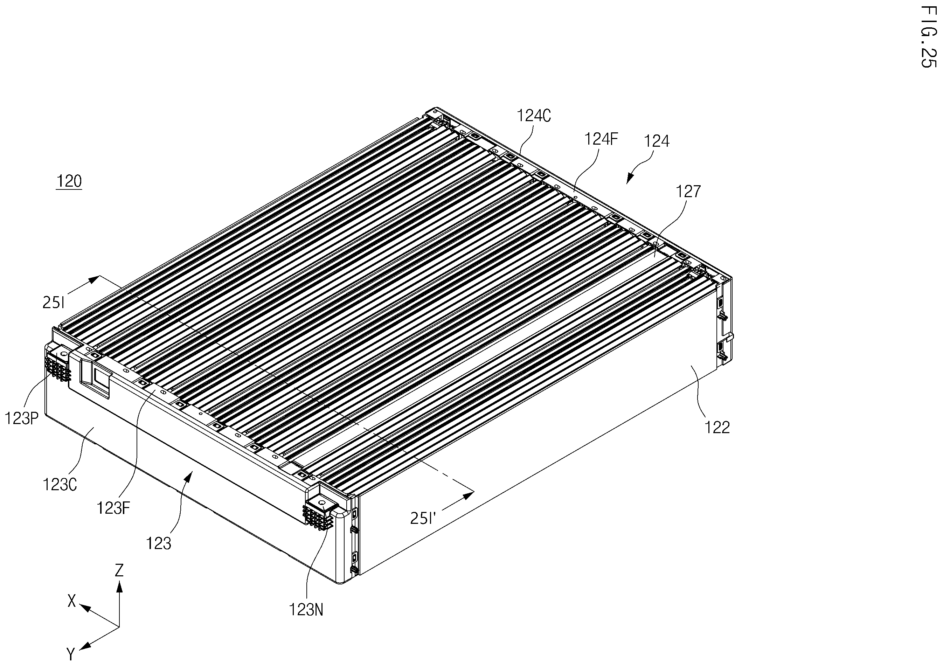

FIG. 25 is a perspective view of a battery cell assembly 120 according to embodiments.

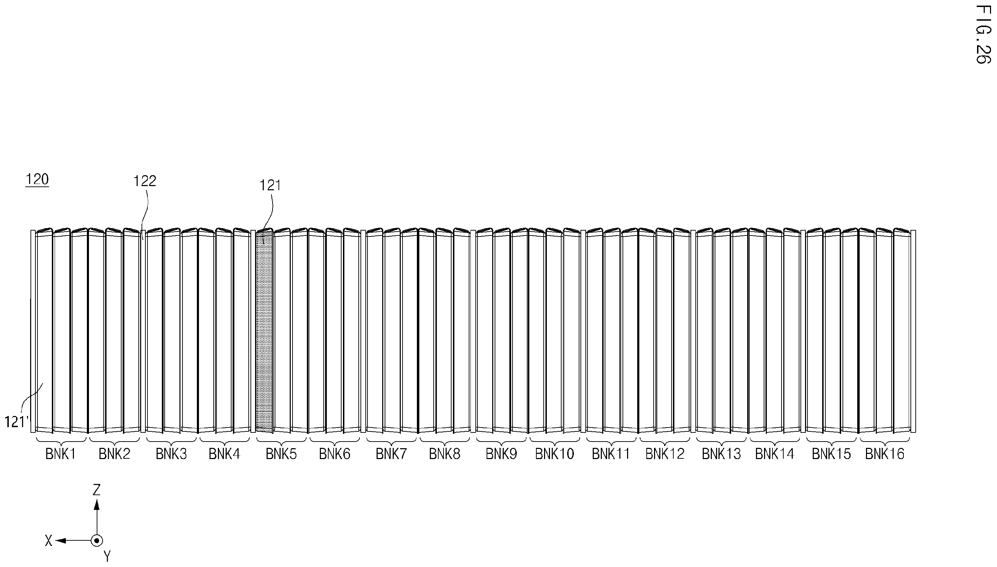

FIG. 26 is a cross-sectional view taken along line 25A-25A' of FIG. 25.

Referring to FIGS. 25 and 26, the battery cell assembly 120 may include a plurality of battery cells 121 and 121', pads 122, a first integrated circuit assembly 123, a second integrated circuit assembly 124, and a flexible flat cable (FFC) assembly 127.

The battery cell 121 is substantially the same as that described above with reference to FIGS. 23 and 24. A position of the battery cell 121 may be determined according to a scenario of a target internal short circuit occurrence location.

Each of the battery cells 121' is substantially the same as the battery cells 121 described above with reference to FIGS. 23 to 24, except that the battery cells 121' do not include the variable resistance structure VRS (see FIG. 7). The plurality of battery cells 121 and 121' may be arranged in the X-axis direction. The plurality of battery cells 121 and 121' may be coupled to each other via, for example, an adhesive. According to embodiments, the battery cell assembly 120 may include normal battery cells 121', and a battery cell 121 that includes the variable resistance structure VRN (see FIG. 7) to simulate an internal short circuit.

The plurality of battery cells 121 and 121' may constitute a plurality of banks BNK1, BNK2, BNK3, BNK4, BNK5, BNK6, BNK7, BNK8, BNK9, BNK10, BNK11, BNK12, BNK13, BNK14, BNK15, and BNK16. For example, some battery cells 121' (e.g., three battery cells 121') may be connected to each other in parallel and constitute the bank BNK1. For example, some battery cells 121' may be connected to each other in parallel and constitute the bank BNK2. For example, some battery cells 121' may be connected to each other in parallel and constitute the bank BNK3. For example, some battery cells 121' may be connected to each other in parallel and constitute the bank BNK4. For example, some battery cells 121 and 121' may be connected to each other in parallel and constitute the bank BNK5. For example, some battery cells 121' may be connected to each other in parallel and constitute the bank BNK6. For example, some battery cells 121' may be connected to each other in parallel and constitute the bank BNK7. For example, some battery cells 121' may be connected to each other in parallel and constitute the bank BNK8. For example, some battery cells 121' may be connected to each other in parallel and constitute the bank BNK9. For example, some battery cells 121' may be connected to each other in parallel and constitute the bank BNK10. For example, some battery cells 121' may be connected to each other in parallel and constitute the bank BNK11. For example, some battery cells 121' may be connected to each other in parallel and constitute the bank BNK12. For example, some battery cells 121' may be connected to each other in parallel and constitute the bank BNK13. For example, some battery cells 121' may be connected to each other in parallel and constitute the bank BNK14. For example, some battery cells 121' may be connected to each other in parallel and constitute the bank BNK15. For example, some battery cells 121' may be connected to each other in parallel and constitute the bank BNK16. A plurality of banks BNK1 may be connected in series.

A resulting connection form of the plurality of battery cells 121 and 121' may be referred to as a 3-parallel-16 serial (3P-16S) form but is only an example and should not be understood as limiting the technical idea of the present disclosure in any sense. The number of banks to be connected in series and the number of battery cells 121 and 121' to be included in the plurality of banks may be determined according to a voltage and a current to be output from the battery cell assembly 120.

The pads 122 may absorb the swelling of the plurality of battery cells 121 and 121'. Each of the pads 122 may include polyurethane (PU). Each of the pads 122 may include a fire-resistant material such as a silicone. As a non-limiting example, two of the plurality of banks BNK1 to BNK16 may be interposed between neighboring pads 122.

The first integrated circuit assembly 123 may include an insulating frame 123F, a first integrated circuit, bus bars 123P and 123N, and an insulating cover 123C. The second integrated circuit assembly 124 may include an insulating frame 124F, a second integrated circuit, and an insulating cover 124C.

The first and second integrated circuit assemblies 123 and 124 may provide electrical connection between the plurality of battery cells 121 and 121', output resulting voltages of the plurality of battery cells 121 and 121', and include physical and functional components for measuring voltages (or currents) of nodes inside a circuit composed of the plurality of battery cells 121 and 121'.

The insulating frame 123F may include an insulating material such as plastic. The insulating frame 123F may cover front sides of the plurality of battery cells 121 and 121'. The insulating frame 123F may support the first integrated circuit, the bus bars 123P and 123N, and the insulating cover 123C.

The bus bar 123P may be short-circuited to the positive electrode leads 121P of one or more battery cells 121 and 121' of the first bank BNK1, and the bus bar 123N may be short-circuited to the negative electrode leads 121N of one or more battery cells 121 and 121' of the last bank BNK16. The bus bar 123P may be welded to the positive electrode leads 121P of one or more battery cells 121' of the first bank BNK1, and the bus bar 123N may be welded to the negative electrode leads 121N of one or more battery cells 121' of the last bank BNK16. Resulting voltages of the plurality of battery cells 121 and 121' of the battery cell assembly 120 may be output through the bus bars 123P and 123N. The bus bars 123P and 123N may be fixed to the insulating frame 123F.

The first integrated circuit may be mounted on the insulating frame 123F. The positive electrode leads 121P and the negative electrode leads 121N that are welded together may form nodes inside the battery cell assembly 120. The first integrated circuit may be electrically connected to the nodes inside the battery cell assembly 120 through a sensing plate or a wire and be configured to measure voltages of the nodes.

The insulating cover 123C may include an insulating material such as plastic. The insulating cover 123C may be interference-fitted into the insulating frame 123F. The insulating cover 123F may cover the first integrated circuit and thus electrical elements of the first integrated circuit assembly 123 may be protected.

The insulating frame 124F may include an insulating material such as plastic. The insulating frame 124F may cover rear sides of the plurality of battery cells 121 and 121'. The insulating frame 124F may support the first integrated circuit and the insulating cover 124C.

The second integrated circuit may be mounted on the insulating frame 124F. The second integrated circuit may be electrically connected to the nodes inside the battery cell assembly 120 through a sensing plate or a wire and be configured to measure voltages of the nodes.

The first integrated circuit may be configured to measure voltages of nodes composed of the positive electrode leads 121P of the odd-numbered banks BNK1, BNK3, BNK5, BNK7, BNK9, BNK11, BNK13 and BNK15, and the negative electrode leads 121N of the even-numbered banks BNK2, BNK4, BNK6, BNK8, BNK10, BNK12, BNK14 and BNK16. The first integrated circuit may be configured to measure voltages of nodes composed of the negative electrode leads 121N of the odd-numbered banks BNK1, BNK3, BNK5, BNK7, BNK9, BNK11, BNK13 and BNK15, and the positive electrode leads 121P of the even-numbered banks BNK2, BNK4, BNK6, BNK8, BNK10, BNK12, BNK14 and BNK16.

The insulating cover 124C may include an insulating material such as plastic. The insulating cover 124C may be interference-fitted into the insulating frame 124F. The insulating cover 124F may cover the second integrated circuit and thus electrical elements of the second integrated circuit assembly 124 may be protected.

The FFC assembly 127 may provide electrical connection between the first integrated circuit of the first integrated circuit assembly 123 and the second integrated circuit of the second integrated circuit assembly 124. Accordingly, measured values, such as temperatures and voltages, collected from the second integrated circuit of the second integrated circuit assembly 124 may be transmitted to the first integrated circuit of the first integrated circuit assembly 123 through the FFC assembly 127.

### (Tenth Embodiment)

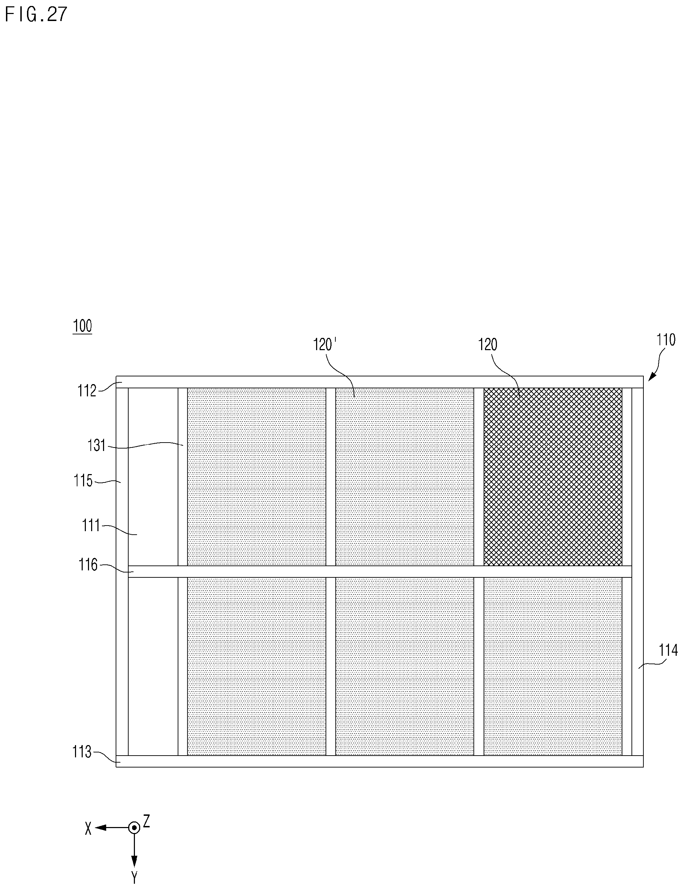

FIG. 27 is a plan view of a battery pack 100 according to embodiments.

Referring to FIGS. 25 to 27, the battery pack 100 may include a pack housing 110, a plurality of battery cell assemblies 120 and 120', and cross-beams 131. The battery pack 100 may be a final product to be mounted in an application such as a vehicle.

The housing 110 may provide a space for mounting the plurality of battery cell assemblies 120 and 120' therein. The pack housing 110 may include a base plate 111, side walls 112, 113, 114, and 115, and a center beam 116.

Here, two directions substantially parallel to a mounting surface (i.e., a surface facing the battery cell assembly 120) of the base plate 111 are defined as the X-axis direction and the Y-axis direction, and a direction substantially perpendicular to the mounting surface of the base plate 111 is defined as a Z-axis direction. The X-axis direction, the Y-axis direction, and the Z-axis direction may be substantially perpendicular to one another.

Each of the base plate 111 and the side walls 112 and 113 may be provided by an extrusion process. An extrusion direction of each of the base plate 111 and the side walls 112 and 113 may be the X-axis direction. That is, a YZ cross-section of each of the base plate 111 and the side walls 112 and 113 may be constant according to a position in the X-axis direction except for deformation due to additional tooling. Here, the YZ cross-section may be substantially parallel to the Y-axis direction and the Z-axis direction and be substantially perpendicular to the X-axis direction. The base plate 111 and the side walls 112 and 113 may be arranged in the Y-axis direction. The side walls 114 and 115 may also be provided by the extrusion process.

According to embodiments, the base plate 111 and the side walls 112 and 113 may be coupled by friction stir welding. The base plate 111 may include a plurality of unit plates coupled to each other by friction stir welding.

The center beam 116 may extend in the X-axis direction. The center beam 116 may be interposed between the side walls 112 and 113. The center beam 116 may be included in a center plate that is one of the plurality of unit plates coupled to each other by friction stir welding. Accordingly, the center beam 116 may be formed together with the center plate and be an element integrally formed with the center plate.

The base plate 111 may include a plurality of cooling channels. The plurality of cooling channels may provide a passage for moving, for example, a refrigerant such as water. The plurality of cooling channels may be formed by the extrusion process. The plurality of cooling channels may extend in the X-axis direction. The plurality of cooling channels may be spaced apart from each other in the Y-axis direction.

The plurality of battery cell assemblies 120 and 120' may be on the base plate 111 of the pack housing 110. The base plate 111 may support the plurality of battery cell assemblies 120 and 120'. The side walls 112, 113, 114, and 115 may horizontally surround the plurality of battery cell assemblies 120 and 120'. The side walls 112, 113, 114, and 115 may protect the plurality of battery cell assemblies 120 and 120'.

The battery cell assembly 120 is substantially the same as that described above with reference to FIGS. 25 and 26. Each of the battery cell assemblies 120' is the same as the battery cell assembly 120 but may include only normal battery cells 121'. That is, in the battery cell assemblies 120', the battery cell 121 may be replaced with the battery cell 121'. A position of the battery cell assembly 120 may be determined according to a scenario of a target internal short circuit occurrence location.

The center beam 116 and the cross-beams 131 may isolate the plurality of battery cell assemblies 120 and 120' from each other. The plurality of battery cell assemblies 120 and 120' may be spaced apart from each other in the Y-axis direction with the center beam 116 interposed therebetween. The center beam 116 may be interposed between the plurality of battery cell assemblies 120 and 120'. The plurality of battery cell assemblies 120 and 120' may be spaced apart from each other in the X-axis direction with the cross-beams 131 interposed therebetween. The cross-beams 131 may be interposed between the plurality of battery cell assemblies 120 and 120'.

In FIG. 27, an arrangement of the plurality of battery cell assemblies 120 and 120' may be a 3x2 array. The arrangement of the plurality of battery cell assemblies 120 and 120' of FIG. 27 is a non-limiting example and should not be understood as limiting the technical idea of the present disclosure in any sense. Those of ordinary skill in the art will be able to easily derive the plurality of battery cell assemblies 120 and 120' arranged in an MxN array (here, M and N are each an integer of 2 or more), based on the above description.

The battery pack 100 may further include a lid coupled to the side walls 112, 113, 114, and 115 of the pack housing 110. The lid may cover elements, such as the plurality of battery cell assemblies 120 and 120' and electronic components, inside the battery pack 100. The lid may be fixed to the pack housing 110 by a mechanical coupling means such as bolting.

The battery pack 100 may further include exhaust devices coupled to the side walls 114 and 115. One of the side walls 114 and 115 may include exhaust holes connected to the exhaust devices. The exhaust devices may be configured to delay thermal propagation by discharging a high-temperature gas from the inside of the battery pack 100 to the outside when a thermal runaway event occurs in the plurality of battery cell assemblies 120 and 120'.

Here, the thermal runaway state of the battery cell assemblies 120 and 120' is a state in which a change of temperature of the battery cell assemblies 120 and 120' accelerates the change of temperature, i.e., uncontrollable positive feedback. A temperature of the battery cell assemblies 120 and 120' that are in the thermal runaway state sharply increases, and a large amount of a high-pressure gas and combustion debris are discharged.

The battery pack 100 may further include a battery management system (BMS). The BMS may be configured to monitor, balance, and control the battery pack 100. The monitoring of the battery pack 100 may include measuring voltages and currents of certain nodes in the battery cell assemblies 120 and 120' and measuring temperatures at set positions in the battery pack 100. The battery pack 100 may include measuring devices for measuring a voltage, a current, and temperature as described above.

The balancing of the battery pack 100 is an operation of reducing a deviation between the battery cell assemblies 120 and 120'. The controlling of the battery pack 100 includes preventing overcharging, over-discharging, and overcurrent. Through monitoring, balancing, and controlling, the battery pack 100 may be operated under optimal conditions, thereby preventing a decrease in the lifespan of each of the battery cell assemblies 120 and 120'.

The battery pack 100 may further include additional electronic components such as a cooling device, a power relay assembly (PRA), and a safety plug. The cooling device may include a cooling fan. The cooling fan may circulate air in the battery pack 100 to prevent overheating of each of the battery cell assemblies 120 and 120'. The PRA may be configured to supply or cut off power from a high-voltage battery to an external load (e.g., a motor of a vehicle). The PRA may cut off power supply to an external load (e.g., a motor of a vehicle) to protect the battery cell assemblies 120 and 120' and the external load, when an abnormal voltage such as a voltage surge occurs. The additional electronic components may be interposed between the plurality of battery cell assemblies 120 and 120' and the side wall 115. A space between the plurality of battery cell assemblies 120 and 120' and the side wall 115 may be referred to as an electronic component mounting area.

The battery pack 100 may further include a plurality of inter-bus bars configured to electrically connect the battery cell assemblies 120 and 120'. The battery cell assemblies 120 and 120' may be connected in series by the plurality of inter-bus bars. Accordingly, the battery pack 100 may be configured to output a high voltage to an external load (e.g., a motor of a vehicle).

### (Eleventh Embodiment)

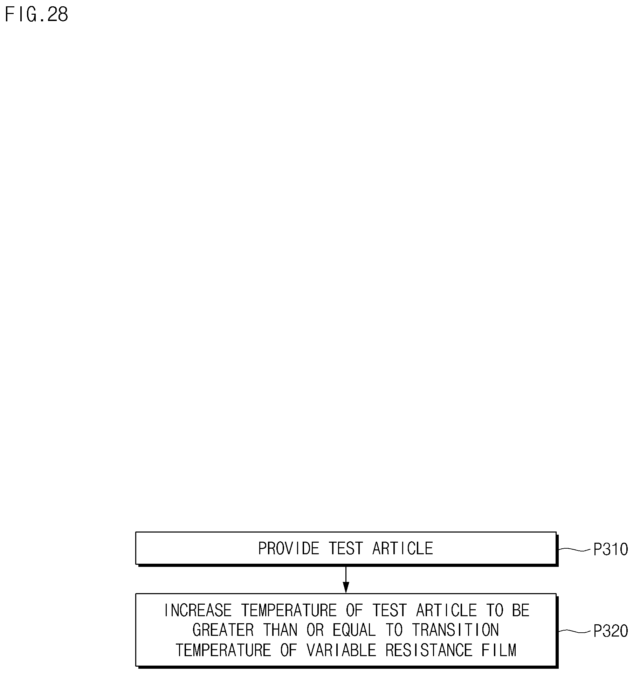

FIG. 28 is a flowchart of an internal short circuit test method according to embodiments.

Referring to FIGS. 16, and 23 to 28, in P110, a test article may be provided. According to embodiments, the test article may include the variable resistance structure VRS. The test article may be the battery cell 121 of FIG. 23, the battery cell assembly 120 of FIG. 25, or the battery pack 100 of FIG. 27.

Next, in P120, a temperature of the test article may be increased to be greater than or equal to a transition temperature of the variable resistance film VF. Accordingly, the test article may be in an internal short circuit state, and an internal short circuit test may be performed. An internal short circuit may be understood as a state in which in a battery, a positive electrode and a negative electrode are directly in contact with each other and thus are electrically connected to each other, thus may lead to serious thermal runaway, fire or explosion.

In the internal short circuit test, a temperature of the battery cells 121 and 121', a change of voltage and current of the battery cells 121 and 121', a physical change of the battery cells 121 and 121' such as expansion, contraction and leakage, and gas emission from the battery cells 121 and 121' may be monitored.

A result of the internal short circuit test may be used for safety assessments, design improvements, and regulatory compliance reporting. The internal short circuit test is a process for ensuring the safety and reliability of the battery cells 121 and 121', and may contribute to prevention of potential risks of the battery cells 121 and 121' by evaluating reactions of the battery cells 121 and 121' under various scenarios and stress conditions.

Because the variable resistance structure VRS according to embodiments includes a transition metal oxide such as VO₂, it is possible to provide a result of the internal short circuit test with high reproducibility, precision, and accuracy, thus leading to improvement of the reliability of the internal short circuit test and the reliability of a product designed according to the result of the internal short circuit test.

The present disclosure has been described above in more detail with reference to the drawings, the embodiments, etc. However, the configurations illustrated in the drawings or embodiments described in the present specification are only examples of the present disclosure and do not reflect all the technical ideas of the present disclosure and thus it should be understood that various equivalents and modifications that replace the configurations would have been made at the filing date of the present application.

## Claims

1. An electrode assembly comprising:
a positive electrode including a positive electrode current collector, a first positive electrode active material layer on the positive electrode current collector, and a second positive electrode active material layer spaced apart from the first positive electrode active material layer with the positive electrode current collector therebetween;
a negative electrode including a negative electrode current collector, a first negative electrode active material layer on the negative electrode current collector, and a second negative electrode active material layer spaced apart from the first negative electrode active material layer with the negative electrode current collector therebetween;
a separator between the positive electrode and the negative electrode; and
a variable resistance structure in contact with the positive electrode and the negative electrode,
wherein the variable resistance structure includes a conductive foil and a variable resistance film on the conductive foil, and
the variable resistance film includes a transition metal oxide.

2. The electrode assembly of claim 1, wherein the variable resistance film includes VO₂.

3. The electrode assembly of claim 1, wherein the variable resistance structure has a step shape.

4. The electrode assembly of claim 1, wherein the positive electrode current collector includes a positive electrode tab, and
the variable resistance structure includes a first portion on the positive electrode tab and a second portion between the negative electrode and the separator.

5. The electrode assembly of claim 4, wherein the conductive foil is in contact with the positive electrode tab.

6. The electrode assembly of claim 4, wherein the conductive foil is coupled to the positive electrode tab via an adhesive.

7. The electrode assembly of claim 4, wherein the conductive foil is spaced apart from the second negative electrode active material layer with the variable resistance film therebetween.

8. The electrode assembly of claim 4, wherein the variable resistance film is in contact with the second negative electrode active material layer.

9. The electrode assembly of claim 8, wherein the variable resistance structure further includes an insulating layer between the variable resistance film and the negative electrode.

10. The electrode assembly of claim 4, wherein the conductive foil is in contact with the second negative electrode active material layer.

11. The electrode assembly of claim 4, wherein the conductive foil is spaced apart from the positive electrode tab with the variable resistance film therebetween.

12. The electrode assembly of claim 4, wherein the variable resistance film is in contact with the positive electrode tab.

13. The electrode assembly of claim 1, wherein the negative electrode current collector includes a negative electrode tab, and
the variable resistance structure includes a first portion on the negative electrode tab and a second portion between the negative electrode and the separator.

14. The electrode assembly of claim 1, wherein the variable resistance structure includes a first portion between the positive electrode and the separator and a second portion between the negative electrode and the separator.

15. The electrode assembly of claim 14, wherein the positive electrode current collector includes a positive electrode tab,
the negative electrode current collector includes a negative electrode tab, and
the variable resistance structure is spaced apart from each of the positive electrode tab and the negative electrode tab.

16. The electrode assembly of claim 14, wherein the variable resistance structure has a C-shape.

17. An electrode assembly comprising:
a positive electrode including a positive electrode current collector, a first positive electrode active material layer on the positive electrode current collector, and a second positive electrode active material layer spaced apart from the first positive electrode active material layer with the positive electrode current collector therebetween;
a negative electrode including a negative electrode current collector, a first negative electrode active material layer on the negative electrode current collector, and a second negative electrode active material layer spaced apart from the first negative electrode active material layer with the negative electrode current collector therebetween;
a separator between the positive electrode and the negative electrode; and
a variable resistance structure in contact with the positive electrode and the negative electrode,
wherein the variable resistance structure includes a conductive foil and a variable resistance film on the conductive foil, and
first resistivity of the variable resistance film at a first temperature is twice or more second resistivity of the variable resistance film at a second temperature higher than the first temperature.

18. The electrode assembly of claim 17, wherein the first temperature is lower than 341 K, and
the second temperature is higher than 341 K.
